# EUROPEAN PATENT APPLICATION

(11) **EP 2 733 117 A2**
(43) Date of publication of application: **21.05.2014**
(21) Application number: 12811804.9
(22) Date of filing: 13.07.2012
(51) Int. Cl.: C01G 25/02, B82B 3/00, H01L 31/042, B82Y 30/00

(54) **INORGANIC PARTICLE SCATTERING FILM HAVING A GOOD LIGHT-EXTRACTION PERFORMANCE**

(30) Priority: 14.07.2011 KR 20110070128
(71) Applicant: LTC Co., Ltd., Gyeonggi-do 431-060 (KR)
(72) Inventor: RYU, Kwang Hyun, Goyang-si Gyeonggi-do 411-370 (KR); KIM, Hwa Young, Suwon-si Gyeonggi-do 441-885 (KR); KIM, Sung Kook, Seoul 133-778 (KR); LEE, Yong Jin, Icheon-si Gyeonggi-do 467-902 (KR); MIN, Sung Hwan, Daejeon 305-330 (KR)
(74) Representative: Long, Giorgio
(86) International application number: PCT/KR2012/005635
(87) International publication number: WO 2013/009150

(57) **Abstract**

Disclosed are an inorganic fine particle scattering film and a manufacturing method thereof, wherein an inorganic fine particle layer comprising pores is formed on a light emitting device interface or a transparent substrate so as to achieve a high light extraction effect through a light scattering effect, and a planarizing layer is formed on the inorganic fine particle layer so as to show a high flatness and a high hardness. The disclosed inorganic fine particle scattering film is excellent in a light extraction effect, flatness and hardness and thus can be applied in the various fields such as an image display device, a lighting element, a solar cell.

## Description

### Field of the invention

The present invention relates to an inorganic fine particle scattering film and a manufacturing method thereof, wherein an inorganic fine particle layer comprising pores is formed on a light emitting device interface or a transparent substrate so as to achieve a high light extraction effect through a light scattering effect, and a planarizing layer is formed on the inorganic fine particle layer so as to show a high flatness and a high hardness.

### Description of the Prior Art

In the case of a light emitting device, when light is emitted, reflection loss occurs in optical power due a difference in a refractive index on a light emitting device interface. Till now, a method of forming an anti-reflective film on a surface or a transparent substrate in order to increase the optical power of the light emitting device, or a method of increasing the optical power through scattering by forming unevenness through etching on a surface have been researched and developed.

A protective film (anti-reflective film) having light-transmission and anti-reflective function has been provided to a transparent substrate, such as a glass or plastic substrate, especially used for a lens or an image display device. In general, the anti-reflective film is formed as a multi-layered film (a high refractive index layer, an intermediate refractive index layer, and a low refractive index layer) comprising transparent thin film layers comprising a plurality of metal oxides. The transparent thin film layers are layered upon each other and have different refractive indexes. When the anti-reflective film is manufactured by coating, a binder resin is used as a matrix for forming the film. In general, such a binder resin has a refractive index ranging from 1.45 to 1.55. Thus, by selecting the kind and amount of inorganic fine particles used for each layer, the refractive index of the layer is appropriately adjusted. Especially, for the high refractive index layer, inorganic fine particles having a high refractive index are required. It is very important to uniformly disperse inorganic fine particles having a high refractive index without aggregation on a matrix with a sufficient film strength.

Unlike this, in a low reflective surface structure having a scattering property, light emitted from a luminous body reflects at the interface and returns to the light emitting device while its loss by conversion into heat energy is minimized. Thus, it is possible to achieve a high light extraction effect. Due to such an advantage, a low-reflective film with a scattering property is suitable for being employed in a solar cell, or the like as well as the light emitting device. In other words, there have been suggested various solutions for disturbing a substrate-air interface (for example, a micro lens or a roughened surface) so as to have an effect on light reaching the interface. In order to improve light extraction efficiency through scattering, research on manufacturing a film having a low-reflective surface through light scattering by forming unevenness or nanowires on a light emitting device surface, and also research on corrugating an electrode structure (publication [M.Fujita, et al.; Jpn.J.Appl.Phys. 44 (6A),pp.3669-3677 (2005)]) have been actively conducted. However, it is expected that such a structure formed with surface unevenness, in electrode configuration on a scattering layer surface, finally has a harmful effect on the electric field of a device. Thus, it has a limitation in its application range.

There has been another method of introducing a scattering element into a substrate or an organic binder (refer to R. Bathelt, Organic Electronics 8, 293-299(2007), WO2002037580A1 or Korean Patent Application Publication 10-2009-0128487) to stop a substrate mode and change the direction of light from a device. Also, there have been previous several attempts to introduce a scattering or diffraction element into a core-substrate interface so as to disturb the interface. Especially, from these attempts, Korean Patent Application Publication 10-2009-0128487 suggests a light scattering layer comprising two kinds of fillers (Nf₁ or Nf₂) with different refractive indexes within an organic binder (refractive index Nb). Refractive indexes for constituents of a light scattering layer satisfy Nf₂> Nb > Nf₁, and due to a difference in a refractive index among the three constituents, a light scattering phenomenon occurs. However, in the case where inorganic particles having a different refractive index from that of an organic binder are introduced into the organic binder, since a difference between the organic binder and the inorganic particles in the refractive index is not large, a scattering effect is not high. Thus, there is a problem in that a light extraction effect may be halved.

Also, in the structure of an organic light emitting device (OLED), there has been recently reported research on forming a light scattering layer on a transparent substrate so as to maximize light extraction efficiency (R. Bathelt, Organic Electronics 8, 293-299(2007)). In this research, a method of enhancing light scattering efficiency by using a polyacrylic scattering film comprising pores was reported. Herein, in the case of a resin used for this method, in use for a long time, a reduction in luminous efficiency may be caused due to discoloration or the like by moisture. Also, a resin used as organic backfill has a low refractive index (n=1.4 to 1.5), and thus has a problem in that its scattering effect cannot be further improved.

Also, Korean Patent Application Publication 10-2010-0138939 discloses a silicon oxide based-scattering glass plate obtained by forming pores in a high refractive index glass. However, such a scattering glass plate has a problem in that it cannot be directly applied on a light emitting device surface in its process, and is not suitable for employment in various shapes and forms of substrates in view of its process.

Accordingly, the present inventors could maximize a light scattering effect by introducing, as scattering particles, inorganic oxide particles having a higher refractive index (e.g. 1.7 or more) than pores (refractive index∼1). In other words, they have invented an optical thin film having a high light extraction effect through light scattering by preparing nano-sized particle powder with a high refractive index, and forming it into an inorganic compound nano particle film having pores through coating on a luminous body surface or various shapes and forms of substrates. Also, by forming a planarizing layer on an inorganic fine particle layer, the present inventors have invented an inorganic fine particle scattering film which is excellent in flatness and hardness and thus has no harmful effect on the electric field and the electric conductivity of a device.

### Summary of the invention

An object of the present invention is to provide an inorganic fine particle scattering film showing a high light extraction effect.

Another object of the present invention is to provide an inorganic fine particle scattering film excellent in flatness and hardness.

A further object of the present invention is to provide a method of manufacturing the inorganic fine particle scattering film.

An inorganic fine particle scattering film according to the present invention is a scattering film for improving light extraction, and comprises an inorganic fine particle layer comprising pores; and a planarizing layer for protecting and planarizing the inorganic fine particle layer.

In one embodiment of the present invention, inorganic fine particles of the inorganic fine particle layer have a refractive index of 1.7 or more, preferably of 1.7 to 3.0. In one embodiment of the present invention, inorganic fine particles of the inorganic fine particle layer comprise metal oxide comprising a metal selected from the group consisting of Li, Be, B, Na, Mg, Si, K, Ca, Sc, V, Cr, Mn, Fe, Ni, Cu, Zn, Ga, Ge, Rb, Sr, Y, Mo, Cs, Ba, La, Hf, W, Tl, Pb, Ce, Pr, Nd, Pm, Sm, Eu, Gd, Tb, Dy, Ho, Er, Tm, Yb, Ti, Sb, Sn, Zr, Ce, Ta, In and a combination thereof.

In one embodiment of the present invention, the metal oxide is selected from the group consisting of zirconium oxide (ZrO₂); hafnium oxide (HfO₂); tantalium oxide (Ta₂O₅); titanium oxide (TiO₂); yttrium oxide (Y₂O₃): zinc oxide (ZnO); zirconium oxide stabilized or partially stabilized by yttrium oxide, magnesium oxide (MgO), calcium oxide (CaO) or cerium oxide (CeO₂) (Y₂O₃-ZrO₂, MgO-ZrO₂, CaO-ZrO₂, CeO2-ZrO₂); and a mixture thereof.

In one embodiment of the present invention, the metal oxide is zirconium oxide stabilized or partially stabilized by yttrium oxide.

In one embodiment of the present invention, inorganic fine particles of the inorganic fine particle layer have a particle average size (D₅₀) ranging from 1nm to 1*µ*m, preferably from 5nm to 500 nm.

In one embodiment of the present invention, the planarizing layer is an organic coating film forming material, and the organic coating film forming material is a polyacrylic resin, a polyimide-based resin or a mixture thereof.

In one embodiment of the present invention, the planarizing layer is an inorganic coating film forming material, and the inorganic coating film forming material comprises silicon compounds.

In one embodiment of the present invention, the silicon compounds comprise silica, organosilicon, silicate or a mixture thereof.

In one embodiment of the present invention, the inorganic coating film forming material further comprises a compound comprising Al, B, Li or Pb.

In one embodiment of the present invention, thickness of the inorganic fine particle scattering film ranges from 100nm to 30µm.

In one embodiment of the present invention, surface flatness (Ra) of the inorganic fine particle scattering film ranges from 1nm to 10nm.

In one embodiment of the present invention, surface hardness of the inorganic fine particle scattering film ranges from 3H to 9H.

A method of manufacturing an inorganic fine particle scattering film according to the present invention comprises the steps of: providing a substrate; fabricating an inorganic fine particle layer comprising pores on the substrate; and fabricating a planarizing layer on the inorganic fine particle layer.

In one embodiment of the present invention, the step of fabricating the inorganic fine particle layer comprising the pores on the substrate comprises the steps of: applying an inorganic fine particle coating composition comprising inorganic fine particles and a solvent on the substrate; and heating the inorganic fine particle coating composition so as to remove the solvent and form the inorganic fine particle layer comprising the pores.

In one embodiment of the present invention, the step of fabricating the planarizing layer on the inorganic fine particle layer comprises the step of: forming an organic polymer thin film on the inorganic fine particle layer, followed by thermal-curing.

In another embodiment of the present invention, the step of fabricating the planarizing layer on the inorganic fine particle layer comprises the step of: applying an inorganic coating film forming composition on the inorganic fine particle layer; removing a solvent from the inorganic coating film forming composition; and forming the planarizing layer by performing heat-treatment, electron ray-treatment or UV ray-treatment on the inorganic coating film forming composition obtained after removal of the solvent.

In one embodiment of the present invention, the inorganic coating film forming composition comprises a compound selected from the group consisting of silane, siloxane, silsesquioxane, silicate, silanol, silazane and a mixture thereof, and a solvent.

In one embodiment of the present invention, the inorganic coating film forming composition further comprises a compound comprising Al, B, Li or Pb.

In one embodiment of the present invention, the inorganic fine particle coating composition, the organic coating film forming composition or the inorganic coating film forming composition is applied by spin coating, dip-coating, slot-coating or screen printing.

A glass, a light emitting device, a solar cell substrate, an organic polymer film or a lighting element according to the present invention, comprises the inorganic fine particle scattering film.

The inorganic fine particle scattering film according to the present invention is excellent in a light extraction effect, flatness and hardness, and thus can be applied in the various fields such as an image display device, a lighting element, a solar cell and the like.

### Brief description of the drawings

FIG. 1 is a schematic view showing a cross-section of an inorganic fine particle scattering film according to the present invention.
FIG. 2 is a scanning electron microscopic (SEM) photograph of a cross-section of an inorganic fine particle scattering film according to the present invention.
FIG. 3 shows measurement results of surface flatness (AFM (Atomic Force Microscope)) on an inorganic fine particle layer, and an inorganic fine particle layer together with a planarizing layer.
FIG. 4 is a schematic view showing a process of synthesizing ZrO₂ nano powder stabilized by Y₂O₃.
FIG. 5 is an X-ray diffraction view of ZrO₂ nano powder stabilized by Y₂O₃.
FIG. 6 is an SEM photograph of ZrO₂ nano powder stabilized by Y₂O₃.
FIG. 7 is an SEM photograph of ZrO₂ nano powder stabilized by Y₂O₃.
FIG. 8 is a transmission electron microscopic (TEM) photograph of ZrO₂ nano powder stabilized by Y₂O₃.
FIG. 9 is an SEM photograph showing a cross-section of an inorganic fine particle layer with a thickness of 9.8*µ*m, fabricated by Example 2-3.
FIG. 10 is an SEM photograph showing a cross-section of an inorganic fine particle layer with a thickness of 4.4*µ*m, fabricated by Example 2-3.
FIG. 11 is an SEM photograph showing a cross-section of an inorganic fine particle layer with a thickness of 1.8*µ*m, fabricated by Example 2-3.

### Detailed description of the preferred embodiments

### Inorganic fine particle scattering film

The inorganic fine particle scattering film according to the present invention is a scattering film for improving light extraction, and comprises an inorganic fine particle layer comprising pores; and a planarizing layer for protecting and planarizing the inorganic fine particle layer.

In an embodiment of the present invention, inorganic fine particles of the inorganic fine particle layer have a refractive index of 1.7 or more, preferably of 1.7 to 3.0. In an embodiment of the present invention, the inorganic fine particles of the inorganic fine particle layer comprise metal oxide comprising a metal selected from the group consisting of Li, Be, B, Na, Mg, Si, K, Ca, Sc, V, Cr, Mn, Fe, Ni, Cu, Zn, Ga, Ge, Rb, Sr, Y, Mo, Cs, Ba, La, Hf, W, Tl, Pb, Ce, Pr, Nd, Pm, Sm, Eu, Gd, Tb, Dy, Ho, Er, Tm, Yb, Ti, Sb, Sn, Zr, Ce, Ta, In and a combination thereof.

In an embodiment of the present invention, the metal oxide is selected from the group consisting of zirconium oxide (ZrO₂); hafnium oxide (HfO₂); tantalium oxide (Ta₂O₅); titanium oxide (TiO₂); yttrium oxide (Y₂O₃); zinc oxide (ZnO); zirconium oxide stabilized or partially stabilized by yttrium oxide, magnesium oxide (MgO), calcium oxide (CaO) or cerium oxide (CeO₂) (Y₂O₃-ZrO₂, MgO-ZrO₂, CaO-ZrO₂, CeO2-ZrO₂); and a mixture thereof.

In an embodiment of the present invention, the metal oxide is zirconium oxide stabilized or partially stabilized by yttrium oxide.

In an embodiment of the present invention, the inorganic fine particles of the inorganic fine particle layer have an average particle size (D₅₀) ranging from 1nm to 1*µ*m, preferably from 5nm to 500 nm.

In an embodiment of the present invention, the inorganic fine particles of the inorganic fine particle layer are prepared by a co-precipitation method. For example, the inorganic fine particles may be prepared by a series of processes comprising the steps of: preparing an aqueous solution comprising metal oxide; preparing uniform precipitates by adjusting pH through mixing the aqueous solution with a catalyst, a solvent and a neutralizing agent, and by adjusting a reaction temperature; uniformly mixing the precipitates through filtering and washing steps; and adjusting a specific surface area and a crystallinity under a heat treatment condition.

For example, the zirconium oxide stabilized or partially stabilized by yttrium oxide may be prepared by a series of processes comprising the steps of: preparing and purifying a zirconia aqueous solution and an yttria aqueous solution; preparing uniform precipitates by adjusting pH through mixing the aqueous solutions with a catalyst, a solvent and a neutralizing agent, and by adjusting a reaction temperature; uniformly mixing the precipitates through filtering and washing steps; and adjusting a specific surface area and a crystallinity under a heat treatment condition.

In the case of zirconia, zirconyl chloride octahydrate (ZrOCl₃·8H₂O), zirconyl nitrate hydrate (ZrO(NO₃)₂·xH₂O) or zirconium sulfate may be used, and in the case of yttria, yttrium nitrate hexahydrate (Y(NO₃)₃·6H₂O) or yttrium chloride hexahydrate (YCl₃·6H₂O) may be used.

As the neutralizing agent, at least one kind of material from among ammonium hydroxide (NH₄OH), ammonium carbonate ((NH₄)₂CO₃), ammonium bicarbonate (NH₄HCO₃), sodium hydroxide (NaOH), and potassium hydroxide (KOH) may be used.

Raw materials in suitable amounts are dissolved in water and the resultant solution is subjected to a filtering step. Then, a catalyst is dropped to the solution so as to co-precipitate the materials.

After the precipitates are produced, the adjustment of the reaction temperature may adjust the particle size distribution and the specific surface area of ZrO₂ nano particles stabilized by Y₂O₃. The reaction temperature for synthesis may range from room temperature (20°C) to 100°C. The precipitates are separated into powder and liquid through a filtering step and subjected to a washing step.

The precipitates obtained after the above described steps are dehydrated by being dried at 100°C for 24 hours and then subjected to heat-treatment at a temperature range of 200 to 1100°C for 1 to 5 hours so as to obtain spherical powder of several to tens of nanometers.

Through the above described method, it is possible to obtain nano powder having a particle diameter size of 1 to 500 nm, and a particle specific surface area of 5 to 100 m²/g. The shape, the size and the distribution of the formed particles may be observed by a scanning electron microscope (FE-SEM) and a transmission electron microscope (TEM). The crystallinity of the particles may be observed through an X-ray diffractometer (XRD).

The pores are formed between inorganic fine particles while the inorganic fine particles are layered. The size and the amount of the pores can be adjusted by control of the inorganic fine particles, and there is no limitation in the size, the shape and the like.

In an embodiment of the present invention, the inorganic fine particle layer may further comprise a coating film forming material, such as a binder, capable of fixing the surface of the inorganic fine particle layer.

The inorganic fine particle layer comprising the inorganic fine particles, fabricated as described above, has a rough surface (Ra>100Å). Thus, there may occur a flaw such as opening of an electrode directly coated on the layer or distortion of a light emitting device.

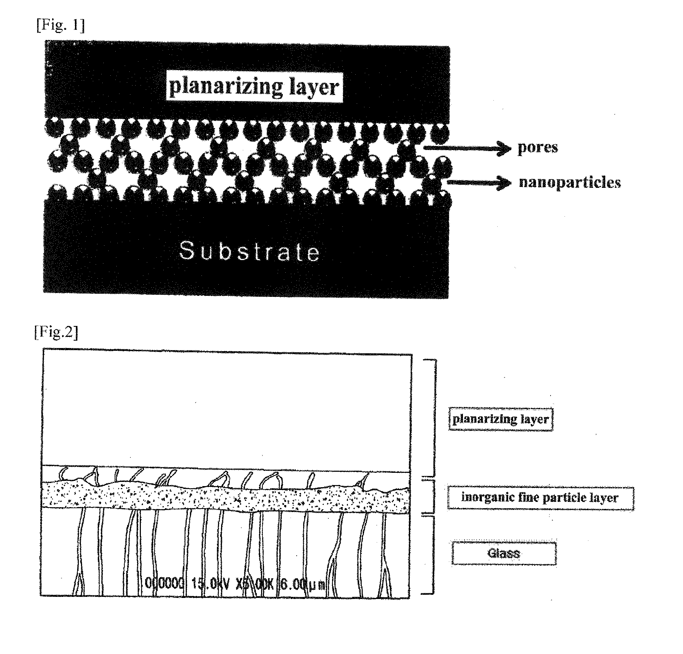

Accordingly, the present inventors have configured the inorganic fine particle scattering film in such a manner that it comprises: an inorganic fine particle layer comprising inorganic fine particles with a high refractive index and pores with a different refractive index from the inorganic fine particles; and a planarizing layer comprising a fixture, that is, a material capable of fixing and planarizing the structure. The above description is shown in FIG. 1.

As a planarizing layer forming material, an adhesive material that can adhere nano particles of the inorganic fine particle layer on a substrate is used. It is used for fixing the mixed-structure of the light scattering nano particles with the pores, improving the adhesive property of the nano particles on the substrate, and also planarizing and strengthening the surface of the light scattering film.

The layering of the planarizing layer on the inorganic fine particle layer may additionally cause various effects. First, the surface of the inorganic fine particle layer may have a flatness (Ra) value of 20nm to 200nm according to coating methods or additives. The planarizing layer may be layered in order to obtain a lower flatness (Ra). The surface flatness (Ra) is measured by an AFM (Atomic Force Microscope). Second, in order to complement the low surface hardness of the inorganic fine particle layer and to prevent the scattering layer structure from collapsing by a physical force, the coating film forming material may be layered. This enhances the mechanical strength of the inorganic fine particle layer structure as well as the surface. The mechanical strength of the surface is measured by a pencil hardness test (KS-D-6711-92) and the surface hardness is measured by a MITSUBISHI pencil.

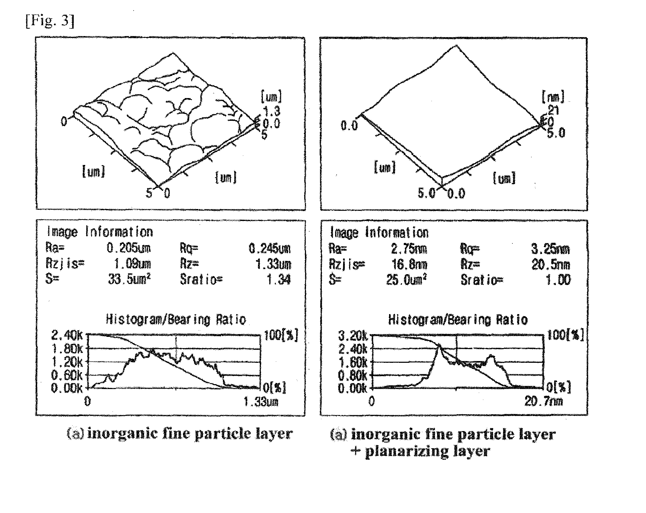

For example, before the fixture was layered, the surface of the inorganic fine particle layer was rough (flatness (Ra) of about 0.18*µ*m). Meanwhile, the layering of the fixture reduced the surface flatness to 2 to 5nm. The surface flatness (Ra) was measured by an AFM (Atomic Force Microscope), and the cross section of the inorganic fine particle layer together with the planarizing layer was observed by a scanning electron microscope (FE-SEM). The results are shown in FIGS. 2 and 3.

Through the electron microscopic photograph shown in FIG. 2, it was found that in view of a cross section, a glass, the inorganic fine particle layer, and the planarizing layer were sequentially layered, and the surface of the planarizing layer was flat.

The mechanical strength of the surface after the layering of the fixture was measured by a pencil hardness test (KS-D-6711-92), and the surface hardness was measured by a MITSUBISHI pencil. As a result, the inorganic fine particle layer had a surface hardness of about 6B. Also, when the planarizing layer was added, the hardness can be increased to 3H to 6H (FIG. 3).

In an embodiment of the present invention, the planarizing layer is an organic coating film forming material, and the organic coating film forming material is a polyacrylic resin, a polyimide-based resin or a mixture thereof.

In an embodiment of the present invention, the planarizing layer is an inorganic coating film forming material. In the present invention, in preparing the inorganic coating film forming material, a SOG (spin on glass) process may be employed. Accordingly, the inorganic coating film forming material may comprise silicon compounds.

In an embodiment of the present invention, the silicon compounds comprise silica, organosilicon, silicate or a mixture thereof. In an embodiment of the present invention, the inorganic coating film forming material further comprises a compound comprising Al, B, Li or Pb.

Also, when the planarizing layer is an inorganic coating film forming material, it is possible to effectively inhibit some problems such as degradation or denaturalization of some organic coating film forming materials in a process (such as CVD (chemical vapor deposition)) requiring high temperature or high energy for manufacturing an organic light emitting device (OLED) or the like.

In an embodiment of the present invention, the planarizing layer is a silica coating film forming material, and the silica film forming material is produced by applying a solution comprising, as a main component, hydrolyzate of a mixture comprising at least one of tetraalkoxysilane, monoalkoxysilane and dialkyldialkoxysilane and heat-treating the applied solution.

In an embodiment of the present invention, the inorganic fine particle scattering film has a thickness of 100nm to 30µm.

In an embodiment of the present invention, the inorganic fine particle scattering film has a surface flatness (Ra) of 1nm to 10nm.

In an embodiment of the present invention, the inorganic fine particle scattering film has a surface hardness of 3H to 9H.

### A method of manufacturing inorganic fine particle scattering film

The method of manufacturing the inorganic fine particle scattering film according to the present invention comprises the steps of: providing a substrate; fabricating an inorganic fine particle layer comprising pores on the substrate; and fabricating a planarizing layer on the inorganic fine particle layer.

In an embodiment of the present invention, the step of fabricating the inorganic fine particle layer comprising the pores on the substrate comprises the steps of: applying an inorganic fine particle coating composition comprising inorganic fine particles and a solvent on the substrate; and heating the inorganic fine particle coating composition so as to remove the solvent and form the inorganic fine particle layer comprising the pores.

In the case where the inorganic fine particle layer is fabricated by coating, it is required to select the kind and the amount of inorganic particles used for coating so as to properly adjust the optical character. For this, it is very important to uniformly disperse the inorganic fine particles without aggregation. In other words, these materials are prepared in a form of nano-size particles, and dispersed within an organic solvent or water. The particles within the dispersion solution have to be excellent in dispersion stability. For this, in the solvent, a dispersing agent, a binder, a plasticizer and the like, together with inorganic fine particles, may be dissolved.

The organic solvent may be any one selected from the group consisting of alcohols, ethers, acetates, ketones and toluene, or a mixture thereof. Specifically, alcohols such as methyl alcohol, ethyl alcohol, isopropyl alcohol, butyl alcohol, isobutyl alcohol, or diacetone alcohol; ethers such as tetrahydrofuran, diethyleneglycoldimethyl ether, diethyleneglycoldiethylether, propyleneglycol monomethylether, propyleneglycolalkylether; acetates such as methylacetate, ethyl acetate, isopropylacetate, butylacetate, propylene glycol methyl ether acetate, propylene glycol ethyl ether acetate, propylene glycol propyl ether acetate, propylene glycol butyl ether acetate; ketones such as acetylacetone or acetone may be used, but the present invention is not limited thereto.

Also, a high boiling point solvent may be used in combination with the solvent. Examples of the high boiling point solvent that can be used in combination with the solvent may comprise N-methyl formamide, N,N-dimethyl formamide, N-methyl acetamide, N,N-dimethyl acetamide, N-methyl pyrrolidone, dimethyl sulfoxide or benzyl ethyl ether solvent.

The method of manufacturing the inorganic fine particle scattering film according to the present invention comprises the step of coating a layer of a material having a high refractive index on a light emitting device surface or a transparent substrate. A nano-structured feature may be provided in an organic material in such a manner that it can produce a nano-structured surface. Then, on the nano-structured surface, a planarizing material may be over-coated in such a manner that it can form the planarizing layer.

The inorganic fine particle coating composition may be applied on the surface of the light emitting device or the substrate by various methods such as spin coating, dip-coating, slot-coating, screen printing and the like.

In an embodiment of the present invention, in fabricating the inorganic fine particle layer, the spin coating method may be used. A dispersion liquid is applied on a glass plate, and is subjected to spin coating. At this time, the concentration of the inorganic material dispersion liquid is adjusted within a range of 5 to 50%. In the spin coating, a thin film is coated under a condition of a rotation speed of 500 to 5000rpm. After the spin coating is completed, heat is applied at 100°C for 30 seconds so as to stabilize glass surface particles and dry the thin film surface.

Further, in order to fix the surface structure of such an inorganic fine particle layer comprising pores, an organic or inorganic binder may be used. Through a drying step for scattering the solvent and organic additives, a coated film is formed. Then, it is sintered at a temperature of 250 to 700°C so as to form the transparent substrate coated with the inorganic fine particle layer.

In an embodiment of the present invention, the step of fabricating the planarizing layer on the inorganic fine particle layer may comprise the step of: forming an organic polymer thin film on the inorganic fine particle layer, followed by thermal-curing. For example, in order to form the planarizing layer, the organic polymer thin film may be formed on the inorganic fine particle layer, followed by thermal-curing at 230°C for 30 minutes.

As mentioned above, in the present invention, in order to fabricate an inorganic coating film forming material as the planarizing layer, an SOG (spin on glass) process may be employed. The SOG process basically indicates that glass dissolved in an organic solvent is rotation-applied on a wafer surface, followed by heat treatment so as to form a silica insulating film. However, in the present invention, the process may be employed in a slightly different manner. Examples of silicon compounds used as a raw material for the SOG process comprise silane, siloxane, silsesquioxane, silicate, silanol, silazane, polysilazane (compounds comprising Si, O, (N, H), alkyl group, alkoxy group, etc.), etc. These materials may be used alone or in combination. Also, such silicon compounds may be dissolved in a solvent, preferably an organic solvent (e.g., alcohol or butyl acetate) so as to prepare an inorganic coating film forming composition.

In an embodiment of the present invention, the inorganic coating film forming composition comprises a compound selected from the group consisting of silane, siloxane, silsesquioxane, silicate, silanol, silazane and a mixture thereof, and a solvent.

By removing the organic solvent from the inorganic coating film forming composition, and sintering the inorganic coating film forming composition, an SOG (Spin On Glass) layer comprising silicic acid glass (SiO₂) as a main constituent can be obtained. Then, depending on the material constituting the SOG material layer, electron rays or UV rays may be irradiated on an SOG material layer so as to obtain the SOG layer comprising silicic acid glass (Si02) as a main constituent.

In an embodiment of the present invention, the step of fabricating the planarizing layer on the inorganic fine particle layer comprises the steps of: applying an inorganic coating film forming composition on the inorganic fine particle layer; removing a solvent from the inorganic coating film forming composition; and forming the planarizing layer by performing heat-treatment, electron ray-treatment or UV ray-treatment on the inorganic coating film forming composition obtained after removal of the solvent.

The silicon compounds as raw materials for the SOG process comprise both organic-based and inorganic-based materials. More specifically, they may comprise methyl siloxane, methyl silsesquioxane, phenyl siloxane, phenyl silsesquioxane, methylphenyl siloxane, methylphenyl silsesquioxane or silicate polymer. Also, the silicon compounds may comprise hydrogen siloxane polymer of general formula (H_{0-1.0}SiO_{1.5-2.0})x, and hydrogen silsesquioxane polymer of general formula (HSiO_{1.5})ₓ (herein, x > about 8). Also, they comprise hydrogen silsesquioxane, alkoxyhydridosiloxane or hydroxyhydridosiloxane. Silicon compounds may additionally comprise organohydridosiloxane polymer of general formula (H_{0-1.0}SiO_{1.5-2.0})ₙ(R_{0-1.0}SiO_{1.5-2.0})ₘ, or organohydridosilsesquioxane polymer of general formula (HSiO_{1.5})ₙ(RSiO_{1.5})ₘ (herein, m > 0, n+m > about 8, and R = alkyl or aryl).

Also, silicon compounds may be generally synthesized by silane reactants such as triethoxysilane, tetraethoxysilane, methyltriethoxysilane, dimethyldiethoxysilane, tetramethoxysilane, methyltrimethoxysilane, trimethoxysilane, dimethyldimethoxysilane, phenyltriethoxysilane, phenyltrimethoxysilane, diphenyldiethoxysilane and diphenyldimethoxysilane. Halosilane, especially chlorosilane, for example, trichlorosilane, methyltrichlorosilane, ethyltrichlorosilane, phenyltrichlorosilane, tetrachlorosilane, dichlorosilane, methyldichlorosilane, dimethyldichlorosilane, chlorotriethoxysilane, chlorotrimethoxysilane, chloromethyltriethoxysilane, chloroethyltriethoxysilane, chlorophenyltriethoxysilane, chloromethyltrimethoxysilane, chloroethyltrimethoxysilane, and chlorophenyltrimethoxysilane may be also used as silane reactants.

In an embodiment of the present invention, the inorganic coating film forming composition may further comprise a compound comprising Al, B, Li or Pb in order to minimize physical break-down, such as a crack, following heat treatment.

The method of fabricating the planarizing layer using the inorganic coating film forming material may comprise, for example, the steps of: applying the inorganic coating film forming composition on the inorganic fine particle layer by spin coating, dip-coating, slot-coating, spray coating, screen printing or the like; forming a coated film through a drying step for scattering a solvent; and fabricating the inorganic coating film forming material by sintering the coated film at a temperature of 250 to 700°C.

In an embodiment of the present invention, the inorganic fine particle coating composition, the organic coating film forming composition or the inorganic coating film forming composition is applied by spin coating, dip-coating, slot-coating or screen printing.

The method for fabricating the inorganic fine particle layer may further comprise the step of preparing a coating liquid in order to form a coating layer. In this case, on the inorganic fine particle layer, the planarizing layer is over-coated. The method for coating the layer may comprise spin coating, dip-coating, slot-coating, spray coating or screen printing, but there is no limitation in the coating method.

In the thin film fabricated by the above described method, a regular transmissivity, a scattering transmissivity, a scattering reflectivity, and a scattering layer may be variously measured depending on a thin film material, a thin film thickness, a thin film forming method, and a pore forming method. These optical characters may be measured by using an UV/Vis spectrometer in a wavelength range of 350 to 800nm.

The inorganic fine particle scattering film according to the present invention is excellent in light extraction performance, flatness and hardness, and thus may be preferably applied in the field of a glass, a light emitting device, a solar cell substrate, an organic polymer film, a lighting element or the like.

Hereinafter, the present invention will be described in detail with reference to following Examples. However, the following Examples are only for illustrative purposes and are not intended to limit the scope of the invention.

### Example

### Example 1. Preparation of inorganic fine particles

### Example 1-1.

12.5wt% of ZrOCl₃·8H₂O and 2wt% of Y (NO₃)₃ · ₆H₂O were dissolved in water, and reacted with a mixture liquid of Ammonium hydroxide (NH₄OH) to prepare a solution (precipitated at pH = 9.00). After the prepared precipitated solution was reacted for 1 hour at room temperature, the reaction was completed. Precipitates and solution were separated through a filtering step, and the separated precipitates were dispersed in and washed with distilled water, and were dehydrated through a filter with pores of 1µm, followed by repetitive washing. The dehydrated precipitates were dried in a dryer at 100°C for 24 hours, and subjected to heat treatment in an electric furnace under an air atmosphere, at 800°C for 1 hour.

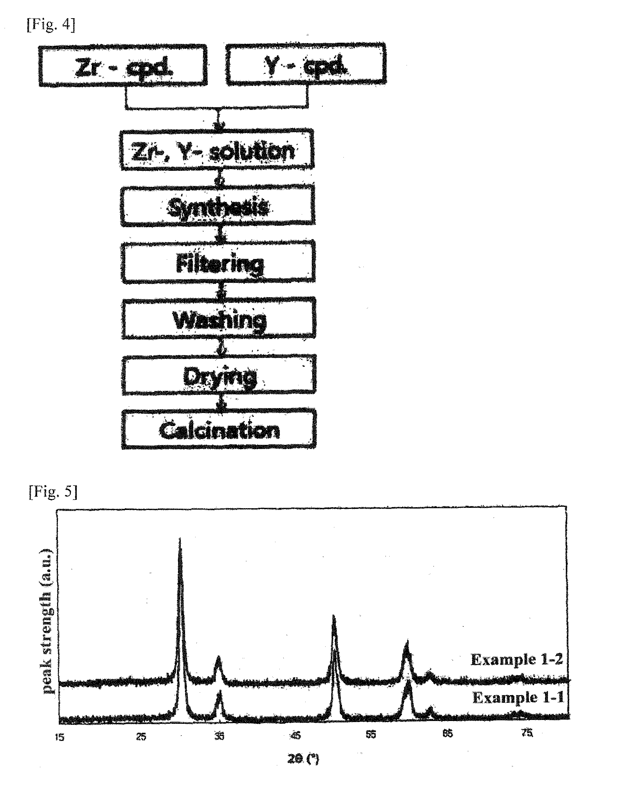

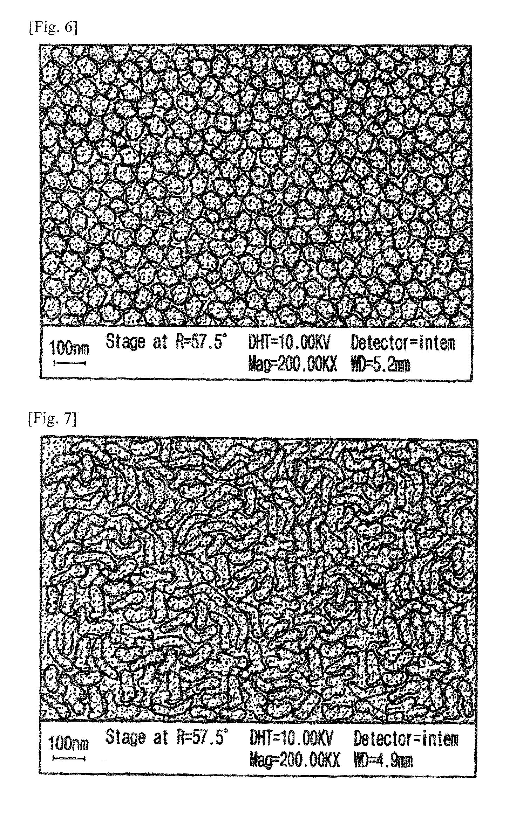

The above described process is shown in FIG. 4. Also, on synthesized nano powder, the x-ray diffraction result and the scanning electron microscopic (SEM) photograph are shown in FIGs. 5 and 6, respectively.

### Example 1-2.

12.5 wt% of ZrOCl₃ · 8H₂O and 2wt% of Y(NO₃)_{3 ·} 6H₂O were dissolved in distilled water comprising additives, and reacted with a mixture liquid of Ammonium hydroxide (NH₄OH) to prepare a solution (precipitated at pH = 9.00). After the prepared precipitated solution was reacted for 1 hour at room temperature, and then reacted at a reaction temperature raised up to 60 °C for 3 hours, the reaction was completed. From then, the same process as that in Example 1-1 was performed. On synthesized nano powder, the x-ray diffraction result and the scanning electron microscopic (SEM) photograph are shown in FIGs. 5 and 7, respectively.

### Example 1-3.

This process was performed in the same manner as described in Example 1-2, except that additives are dropped to a zirconia aqueous solution and a yttria aqueous solution. After the resultant solution was reacted for 1 hour at room temperature, and then further reacted at a reaction temperature raised up to 60 °C for 3 hours. From then, the same process as that in Example 1-1 was performed. The particles obtained from this method had a smaller size than those in Example 1-2.

From the result, it can be seen that YSZ powder prepared in Example 1-1 showed a more developed crystallinity (see FIG. 5).

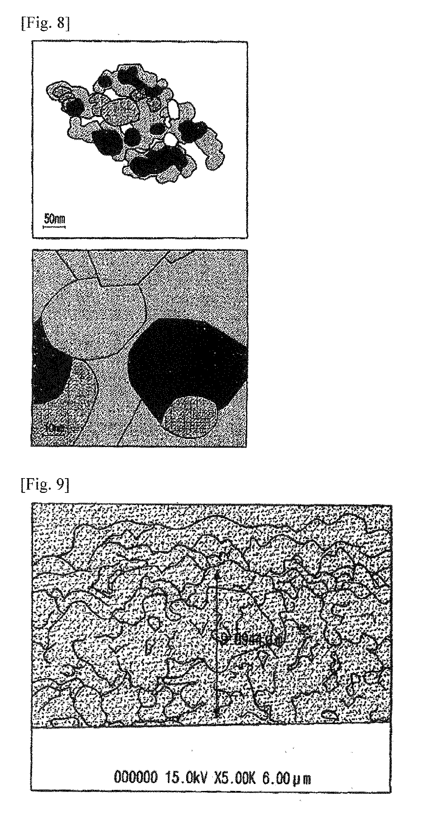

Through the transmission electron microscopic (TEM) photograph of YSZ particles prepared in Example 1-1, it was possible to confirm the shape and size of the particles. It was found that the particle size ranges 50 to 60nm through the transmission electron microscopic photograph. The result is shown in FIG. 8.

### Example 2. Fabrication of an inorganic fine particle scattering film

### Example 2-1.

Nano-sized zirconia powder was mixed with additives in an organic solvent. The resultant solution was milled for 3 hours to prepare a dispersion liquid. The dispersion liquid was coated on a glass substrate. After the solvent was dried in a dryer at 100°C for 30 seconds, the coated liquid was heated at 250°C for 30 minutes so as to layer an inorganic fine particle layer. Then, on the inorganic fine particle layer, a polyacrylic compound was coated to layer a planarizing layer.

### Example 2-2.

By using Nano-sized yttria powder, a dispersion liquid was prepared in the same manner as described in Example 2-1, and an inorganic fine particle layer and a planarizing layer were layered.

### Example 2-3.

By using zirconia (YSZ) stabilized by yttria with a size of 50 to 60nm, a dispersion liquid was prepared in the same manner as described in Example 2-1, and an inorganic fine particle layer and a planarizing layer were layered. Herein, by varying a coating condition, the inorganic fine particle layer was layered with a thickness of 1 to 10*µ*m.

### Example 2-4.

Zirconia (YSZ) powder stabilized by yttria with a size of 50 to 60nm was mixed with additives in an organic solvent. The resultant solution was milled for 48 hours to prepare a dispersion liquid. The dispersion liquid was coated with a thickness of 0.5 to 2*µ*m on a glass substrate by varying a coating condition. The coated glass substrate was dried in a dryer at 140°C for 5 minutes so as to remove the solvent. Then, the substrate was heated at 500°C for 30 minutes so as to perform heat treatment on an inorganic fine particle layer.

After the inorganic fine particle layer was coated, a planarizing layer was coated thereon. Herein, the planarizing layer was formed by applying 0.8g of an SOG coating liquid (TOK, LML-series) on a glass substrate, followed by spin coating. Then, under a nitrogen atmosphere, hard-baking was performed at 500°C for 30 minutes so as to provide scattering glass.

### Comparative Example 1

A glass substrate was coated with a silicon organic compound having a pore forming factor thereon, and dried in a dryer at 100°C for 30 seconds to remove a solvent. Then, the substrate was heated at 230°C for 30 minutes so as to form a silicon oxide layer comprising pores on a glass.

### Comparative Example 2

The glass substrate only used in Example 2 and Comparative Example 1 was used.

### Comparative Example 3

On a glass substrate, an SOG coating liquid (TOK, LML-series) was spin-coated at 400rpm for 30 seconds. Then, on a hot plate, through pre-baking at 150°C for 3 minutes, the solvent was dried. Then, under a nitrogen atmosphere, hard-baking was performed at 500°C for 30 minutes.

On the glass substrate comprising the scattering film, prepared in Examples 2-1, 2-2, 2-3 and 2-4 and Comparative Example 1, the glass substrate used in Comparative Example 2, and the glass substrate coated with only the SOG coating liquid, prepared in Comparative Example 3, transmissivity and reflectivity were measured by an UV/Vis spectrometer. From these results, these values at a wavelength of 550nm were noted in Table 1.

**[Table 1]**

| | inorganic fine particle layer | Inorganic fine particle layer thickness (*µ*m) | scattering transmissivity (%) | regular transmissivity (%) | Total reflectivity (%) |
|---|---|---|---|---|---|
| Example 2-1 | ZrO₂ | 1.8 | 49.8 | 36.9 | 11.2 |
| Example 2-2 | Y₂O₃ | 2.1 | 49.4 | 38.6 | 10.2 |
| Example 2-3 | YSZ | 9.8 | 50.9 | 1 | 44.7 |
| | | 4.2 | 57.9 | 4.3 | 34.7 |
| | | 2 | 60.6 | 13.8 | 21.2 |
| | | 1.1 | 34.5 | 48.6 | 13.7 |
| Example 2-4 | YSZ | 1.0 | 33.2 | 43.0 | 21.5 |
| Comparative Example 1 | silicon oxide comprising pores | 1.5 | 6 | 84.8 | 7.8 |
| Comparative Example 2 | X | X | 0 | 91.6 | 8.7 |
| Comparative Example 3 | X | X | 0.2 | 92.5 | 7.3 |

As noted in Table 1, in the glass substrate not layered with the scattering layer, in Comparative Example 2, or the glass substrate coated with only the SOG coating liquid, in Comparative Example 3, regular transmission and reflection occurred but scattering of light did not occur. Meanwhile, in the inorganic fine particle layer comprising the pores and the silicon oxide, a low degree of light scattering occurred (Comparative Example 1).

Example 2-1 showed a higher scattering transmissivity than the silicon oxide layer comprising pores. In other words, it can be found that the scattering film comprising OrO₂ inorganic fine particles shows a high scattering efficiency and can improve a light extraction effect.

The scattering layer using Y₂O₃ powder in Example 2-2 also had scattering transmissivity of about 50% and showed a high performance for a light extraction effect.

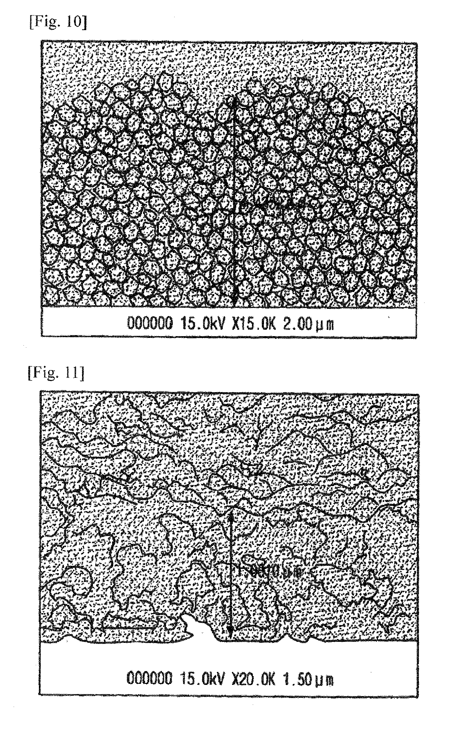

Through scattering transmissivity, it can be understood that Example 2-3 showed a higher light scattering efficiency by YSZ (zirconia stabilized by yttria)-composite oxide inorganic fine particles. According to the thickness of the inorganic fine particle layer, and the coating method, it is possible to adjust regular transmissivity, scattering transmissivity, reflectivity, etc., and to adjust the degree of pores. FIGs. 9, 10, and 11 are SEM photographs showing cross-sections of an inorganic fine particle layer with thicknesses of 2*µ*m, 4.4*µ*m, and 9.8*µ*m, respectively, layered in Example 2-3. It is possible to layer the inorganic fine particle layer with various thicknesses, and to achieve various degrees of pores. Accordingly, it is thought that a light extraction effect can be achieved in various manners.

The planarizing layer in Example 2-4 showed a high scattering transmissivity through coating of the SOG coating liquid. In manufacturing an organic light emitting device (OLED), etc. it is expected that a problem of degradation or denaturation can be effectively inhibited in a process, such as CVD (chemical vapor deposition), requiring high temperature or high energy.

Although an exemplary embodiment of the present invention has been described for illustrative purposes, those skilled in the art will appreciate that various changes may be made without departing from the scope of the invention, and may be substituted with equivalents thereof. Further, many modifications may be implemented without departing from the essential scope of the invention, and then specific conditions and materials may be employed in the claimed features of the invention. Accordingly, it should be understood that the present invention is not limited to any specific embodiment disclosed as a best embodiment planned for implementation of the invention, but comprises all embodiments within the scope of claims of the invention.

## Claims

1. An inorganic fine particle scattering film comprising for improving light extraction, comprising an inorganic fine particle layer comprising pores; and a planarizing layer for protecting and planarizing the inorganic fine particle layer.

2. The inorganic fine particle scattering film as claimed in claim 1, wherein inorganic fine particles of the inorganic fine particle layer have a refractive index of 1.7 or more.

3. The inorganic fine particle scattering film as claimed in claim 1, wherein inorganic fine particles of the inorganic fine particle layer comprises metal oxide comprising a metal selected from the group consisting of Li, Be, B, Na, Mg, Si, K, Ca, Sc, V, Cr, Mn, Fe, Ni, Cu, Zn, Ga, Ge, Rb, Sr, Y, Mo, Cs, Ba, La, Hf, W, Tl, Pb, Ce, Pr, Nd, Pm, Sm, Eu, Gd, Tb, Dy, Ho, Er, Tm, Yb, Ti, Sb, Sn, Zr, Ce, Ta, In and a combination thereof.

4. The inorganic fine particle scattering film as claimed in claim 3, wherein the metal oxide is selected from the group consisting of zirconium oxide (ZrO₂); hafnium oxide (HfO₂); tantalium oxide (Ta₂O₅) ; titanium oxide (TiO₂); yttrium oxide (Y₂O₃) ; zinc oxide (ZnO) ; zirconium oxide stabilized or partially stabilized by yttrium oxide, magnesium oxide (MgO), calcium oxide (CaO) or cerium oxide (CeO₂) (Y₂O₃-ZrO₂, MgO-ZrO₂, CaO-ZrO₂, CeO2-ZrO₂) ; and a mixture thereof.

5. The inorganic fine particle scattering film as claimed in claim 4, wherein the metal oxide is zirconium oxide stabilized or partially stabilized by yttrium oxide.

6. The inorganic fine particle scattering film as claimed in claim 1, wherein inorganic fine particles of the inorganic fine particle layer have a particle average size (D₅₀) ranging from 1nm to 1*µ*m.

7. The inorganic fine particle scattering film as claimed in claim 1, wherein the planarizing layer comprises an organic coating film forming material, and the organic coating film forming material comprises a polyacrylic resin, a polyimide-based resin or a mixture thereof.

8. The inorganic fine particle scattering film as claimed in claim 1, wherein the planarizing layer comprises an inorganic coating film forming material, and the inorganic coating film forming material comprises silicon compounds.

9. The inorganic fine particle scattering film as claimed in claim 8, wherein the silicon compounds comprise silica, organosilicon, silicate or a mixture thereof.

10. The inorganic fine particle scattering film as claimed in claim 8, wherein the inorganic coating film forming material further comprises a compound comprising Al, B, Li or Pb.

11. The inorganic fine particle scattering film as claimed in claim 1, wherein thickness of the inorganic fine particle scattering film ranges from 100nm to 30µm.

12. The inorganic fine particle scattering film as claimed in claim 1, wherein surface flatness (Ra) of the inorganic fine particle scattering film ranges from 1nm to 10nm.

13. The inorganic fine particle scattering film as claimed in claim 1, wherein surface hardness of the inorganic fine particle scattering film ranges from 3H to 9H.

14. A method of manufacturing an inorganic fine particle scattering film, the method comprising the steps of:
providing a substrate;
fabricating an inorganic fine particle layer comprising pores on the substrate; and
fabricating a planarizing layer on the inorganic fine particle layer.

15. The method as claimed in claim 14, wherein the step of fabricating the inorganic fine particle layer comprising the pores on the substrate comprises the steps of:
applying an inorganic fine particle coating composition comprising inorganic fine particles and a solvent on the substrate; and
heating the inorganic fine particle coating composition so as to remove the solvent and form the inorganic fine particle layer comprising the pores.

16. The method as claimed in claim 14, wherein the step of fabricating the planarizing layer on the inorganic fine particle layer comprises the step of: forming an organic polymer thin film on the inorganic fine particle layer, followed by thermal-curing.

17. The method as claimed in claim 14, wherein the step of fabricating the planarizing layer on the inorganic fine particle layer comprises the step of:
applying an inorganic coating film forming composition on the inorganic fine particle layer;
removing a solvent from the inorganic coating film forming composition; and
forming the planarizing layer by performing heat-treatment, electron ray-treatment or UV ray-treatment on the inorganic coating film forming composition obtained after removal of the solvent.

18. The method as claimed in claim 17, wherein the inorganic coating film forming composition comprises a compound selected from the group consisting of silane, siloxane, silsesquioxane, silicate, silanol, silazane and a mixture thereof, and the solvent.

19. The method as claimed in claim 18, wherein the inorganic coating film forming composition further comprises a compound comprising Al, B, Li or Pb.

20. The method as claimed in any one of claims 15 to 17, wherein the inorganic fine particle coating composition, the organic coating film forming composition or the inorganic coating film forming composition is applied by spin coating, dip-coating, slot-coating or screen printing.

21. A glass, a light emitting device, a solar cell substrate, an organic polymer film or a lighting element, comprising the inorganic fine particle scattering film as claimed in any one of claims 1 to 13.
